# EUROPEAN PATENT APPLICATION

(11) **EP 1 808 913 A1**
(43) Date of publication of application: **18.07.2007**
(21) Application number: 06075105.4
(22) Date of filing: 17.01.2006
(51) Int. Cl.: H01L 51/56

(54) **A stamp for preparing a structured layer for use in an organic opto-electric device and a method for preparing such a stamp**

(71) Applicant: Nederlandse Organisatie voor Toegepast-Natuurwetenschappelijk Onderzoek TNO, 2628 VK Delft (NL)
(72) Inventor: Van der Beek, Maurice H. E., 5642 CP Eindhoven (NL); Koetse, Marinus Marc, 5644 EE Eindhoven (NL); Michels, Jasper Joost, 5211 LD 's-Hertogenbosch (NL); Houben, René Jos, 5631 GL Eindhoven (NL); Tacken, Roland Anthony, 5663 SH Geldrop (NL)
(74) Representative: Winckels, Johannes Hubertus F.

(57) **Abstract**

The invention provides a stamp for preparing a structured layer for use in an organic opto-electronic device comprising a body of a curable elastomeric material which body comprises a plurality of cavities shaped in a structure to be obtained in said structured layer. The invention further provides a method for preparing a stamp, a structured substrate for use in an organic opto-electronic device, and a method for preparing a structured substrate for use in an organic opto-electric device.

## Description

The present invention relates to a stamp for preparing a structured layer for use in an organic opto-electric device, methods for preparing such a stamp, a structured substrate for use in an organic opto-electric device, an organic opto-electric device comprising such a structured substrate, and methods for preparing such a structured substrate.

Organic opto-electric devices are nowadays widely used in devices such as light sources, monochrome or multi-colour display devices and matrix-displays of mobile telephones. They can also be used in photovoltaic devices, photodetectors and sensor arrays.

An organic opto-electric device generally comprises an organic layer which is positioned between an anode and a cathode. In case of a light emitting diode (LED), when a voltage is applied between the anode and the cathode, the organic layer will emit light. In contrast, a photovoltaic device constructed in the same way will yield electric current upon illumination. A combination of these two types of devices could yield an opto electronic sensor device.

The substrates of organic opto-electric devices are conventionally prepared by means of a multi-step photolithography technique. The use of such a photolithography technique has, however, some significant drawbacks. It involves a complicated and laborious process which is not suited for simple and large scale manufacturing applications such as roll-to-roll or inline processing. In addition, the solvents used in the photolithography technique may leave artefacts in the electric device because they could permeate the organic layer where it brings about rupture or deterioration of the organic layer, resulting in a considerable reduction of the service life of the electric device.

Object of the present invention is to provide a simple and economically attractive method for preparing substrates for organic opto-electric devices that display an improved (longer) service life.

Surprisingly, it has now been found that this can be established when use is made of a particular stamp.

Accordingly, the present invention relates to a stamp for preparing a structured layer for use in an organic opto-electric device comprising a body of a curable elastomeric material which body comprises a plurality of cavities shaped in a structure to be obtained in said structured layer.

The stamp in accordance with the present invention allows the preparation of organic opto-electric devices on a large scale such as in roll-to-roll and inline production methods, whereas at the same time the devices can be provided with complicated three-dimensional structures. A major advantage of the present stamp is that it can repeatedly be used, and that it allows the formation of a structured layer with, for example, banks and cathode separators (for organic light emitting displays) or optofluidic features (for sensor applications) onto a support layer or patterned transparent layer in one single step, which obviously constitutes a significant improvement over processes wherein use is made of multi-step photolithography. Preferably, the cavities have a longitudinal shape and are positioned parallel or perpendicular to each other.

Preferably, each cavity of the stamp according to the present invention has an opening at a free surface of the body, whereby the cavity narrows towards the opening.

Preferably, each cavity of the stamp comprises a first part and a second part and a passage between the first part and the second part, the first part narrowing towards the passage, the second part having an opening at a free surface of the body and wherein said second part is wider than the passage, the first parts of the cavities having a longitudinal shape and being positioned parallel to each other, the second parts of the cavities having a longitudinal shape and being positioned parallel to each other, and at least two of the second parts of the cavities being connected to each other by means of a cross-connecting passage, said passage having an opening at the free surface of the body which extends between the openings of the second parts connected by the cross-connecting passage.

It will be understood that a stamp having such cavities allow for the preparation of structured substrates comprising both banks and separators.

The skilled person will understand that in the context of the present application the term "parallel" also embraces embodiments wherein the cavities are positioned substantially parallel to each other. The skilled person will also understand that cavities arranged in a perpendicular or parallel fashion do not necessarily need to have the same cavity shape

In a preferred embodiment of the present invention the curable elastomeric material displays wettability properties with respect to an ink which ink comprises a thermocurable material, an electro-magnetic radiation curable material and/or electron beam curable material.

Preferably, the curable elastomeric material is permeable to the ink.

Preferably, the curable elastomeric material displays capillary properties, allowing the ink to pass through the curable elastomeric material.

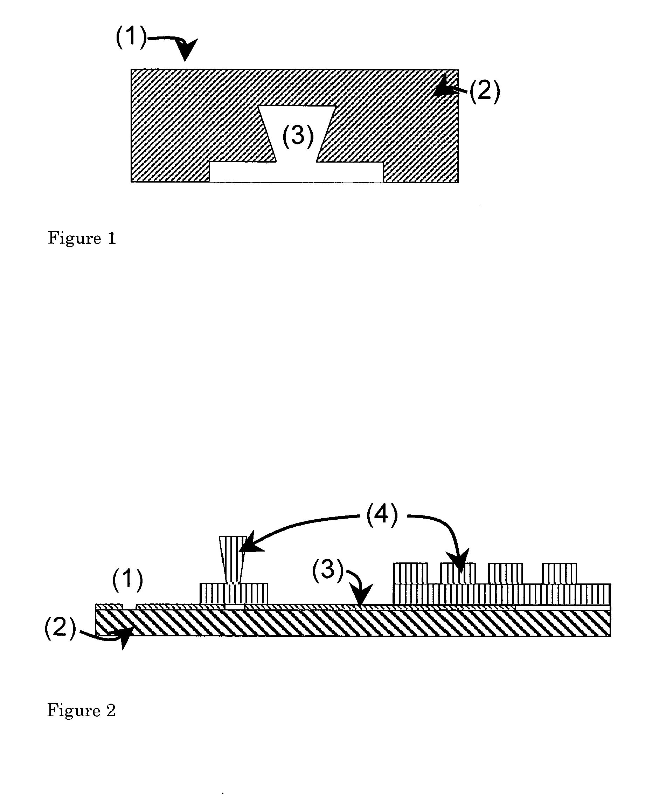

In Figure 1, a stamp has been depicted in accordance with the present invention. The stamp (1) comprises a body of a curable elastomeric material (2) which body comprises a plurality of cavities (3) shaped in a structure to be obtained in said structured layer.

The present invention also provides a method for preparing a stamp for preparing a structured layer for use in an organic opto-electric device, which method comprises the steps of:
(a) providing a support layer;
(b) applying a positive or negative resist layer onto the support layer;
(c) creating a plurality of cavities in the resist layer, which cavities are shaped in a structure to be obtained in said structured layer;
(d) applying a metal layer onto the resist layer and inside the formed cavities obtained in step (c) to form a metal master;
(e) clearing the metal master from the support and resist layer;
(f) applying a layer of a curable elastomeric material onto the metal master to form a stamp; and
(g) clearing the stamp so obtained from the metal master.

In step (b) the positive or negative resist layer can suitably applied onto the support layer by means of a spin coating process or conventional coating process.

In step (c), the plurality of cavities in the resist layer can suitably be created by means of photolithographic techniques, followed by development in a suitable developer

In step (d), the metal layer can suitably be applied onto the resist layer and inside the formed cavities by means of an electroless plating technique, followed by an electrodeposition process.

In step (f), the layer of the curable elastomeric material can suitably be applied onto the metal master by means of a coating process such as a dropcasting process, a dip coating process or a spin coating coating.

Preferably, the cavities created in step (c) have a longitudinal shape and are positioned in parallel or perpendicular with respect to each other. Preferably, the cavities created in step (c) have an opening at a free surface of the body, and the cavities narrow towards the opening.

In a preferred embodiment of the present method, each of the cavities created in step (c) comprises a first part and a second part and a passage between the first part and the second part, the first part narrowing towards the passage, the second part having an opening at a free surface of the body and wherein said second part is wider than the passage, the first parts of the cavities having a longitudinal shape and being positioned parallel to each other, the second parts of the cavities having a longitudinal shape and being positioned parallel to each other, at least two of the second parts of the cavities being connected to each other by means of a cross-connecting passage, said passage having an opening at the free surface of the body which opening extends between the openings of the second parts connected by the cross-connecting passage.

The support layer suitably comprises glass, silicon, metal, a polymer or a combination thereof. Examples of suitable polymers include polycarbonate, polyether etherketone, polymethyl methacrylate, polyamides, Nylon, polyvinyl chloride, polyethylene, polyethylene terephthalate, polybuthylene terephthalate, polyurethanes, polyether sulfone, polypropylene, and polyethyl naphthalate

It will be understood by the skilled person that a resist is formed of a photosensitive resin comprising a UV-absorbing substance and/or a colouring matter.

In a preferred embodiment of the present invention the resist layer is a negative resist layer.

The positive or negative resist layer preferably comprises an electro-magnetic radiation curable material.

Suitably, the metal layer is formed in step (d) by a combination of an initial wet-chemical electroless step and a subsequent electrodeposition step. The initial wet-chemical electroless can suitably be carried out by means of (a) a nickel-phosphorous alloy deposition from a nickel solution containing hypophosphite as reducing agent, (b) a nickel-boron alloy deposition from a solution containing dimethylaminoborane or boron hydride as reducing agent, or (c) essentially pure nickel deposited from a solution containing hydrazin as reducing agent. Alternatively, copper can be deposited from a solution using formaldehyde as reducing agent. The electrodeposition step which is performed after the chemical electroless step can suitably be carried out by means of cathodic nickel deposition from a sulfamate or Watts type electrolyte or copper deposition from an acid copper sulphate electrolyte.

In the method according to the present invention the curable elastomeric material preferably displays wettability properties with respect to an ink which ink comprises a thermocurable material, an electro-magnetic radiation curable material and/or electron beam curable material. Examples of suitable thermocurable materials, electro-magnetic radiation curable materials and electron beam curable materials are silicones, monomeric aliphatic and aromatic (meth)acrylates, epoxy (meth)acrylates, urethane (meth)acrylates, polyether (meth)acrylates, polyester (meth)acrylates vinyl ethers, epoxides, and oxetanes.

Preferably, the curable elastomeric material is permeable to the ink.

Preferably, in the present method, the curable elastomeric material displays capillary properties, allowing the ink to fill the cavities with high precision.

The present invention also provides a structured substrate for use in an organic opto-electric device comprising a support layer, a patterned transparent conductive oxide layer that is applied on the support layer, and a three-dimensional structured layer which comprises banks and cathode separators, wherein the structured layer is made of one part.

The use of the present stamp and stamps made in accordance with the invention allows the simple and therefore advanced manufacturing of structured substrates with complicated structures.

Preferably, in such a structured substrate, the three-dimensional structured layer is applied onto the support layer and/or patterned transparent oxide layer in a single non-lithographic production step using a stamp in accordance with the present invention or a stamp as prepared with the method in accordance with the present invention.

In Figure 2, a structured substrate in accordance with the present invention has been depicted. The structured substrate (1) comprises a support layer (2), a patterned transparent oxide layer (3) and a three-dimensional structured layer (4) that is made of one part.

The present invention further provides an organic opto-electric device which comprises a structured substrate in accordance with the invention. Examples of such organic opto-electric devices include light sources, monochrome or multi-colour display devices, segmented display devices, matrix displays such as for use in mobile phones or televisions.

As mentioned before, the present stamps allow the formation of a three-dimensional structured layer comprising both banks and separators in one single step. The present invention therefore also relates to a method for preparing a structured substrate for use in an organic opto-electric device, which method comprises the steps of:
(a) providing a support layer of which one surface has been coated with a transparent conducting oxide layer;
b) applying a stamp onto the non-coated surface of the support layer and/or transparent conductive oxide layer, which stamp is a stamp in accordance with the present invention or a stamp prepared with the method for preparing a stamp according to the present invention, whereby the lower surface of the stamp is brought into contact with the support layer and/or transparent conductive layer;
(c) establishing a structured layer by filling the cavities of the stamp with an ink which comprises a thermo-curable material, an electro-magnetic radiation curable material and/or an electron beam curable material; and
(d) curing the ink.

Preferably, the cavities of the stamp are filled in step (c) by means of permeation or capillary filling. The ink may also be applied onto the stamp by traditional dipping, blading, and wiping methods. The stamp may suitably be filled under application of a vacuum, which could avoid possible air enclosures.

Further, the present invention also provides a method for preparing a structured substrate for use in an organic opto-electric device, which method comprises the steps of:
(a) providing a support layer of which one surface has been coated with a transparent conductive oxide layer;
(b) applying a stamp onto the non-coated surface of the support layer and/or transparent conductive oxide layer, which stamp is a stamp in accordance with the present invention or a stamp prepared with the method for preparing a stamp according to the present invention, whereby the lower surface of the stamp is brought into contact with the support layer and/or transparent conductive layer, wherein the cavities of the stamp were pre-filled with an ink which comprises a thermo-curable material, an electro-magnetic radiation curable material and/or an electron beam curable material; and
(c) curing the ink.

In steps (b), the transparent conductive oxide layer can be coated onto the support layer by means of a sputtering, physical vapour deposition, or chemical vapour deposition process. Examples of suitable transparent conductive layers include Indium Tin oxide, Fluorine doped Tin Oxide, doped Zink Oxides. Preferably, in the method for preparing the structured substrate, the curing in step (c) or (d) involves thermal, electro-magnetic radiation or electron beam curing.

### Examples

### Example 1 - Premaster without undercut

On a support of Siglass i, a 3 µm film of a positive resist (e.g. HPR 501, Arch chemicals) is spin coated, and soft baked for 1 min at 110 °C. The film is illuminated through a mask containing the desired pattern (Karl Suss, mask aligner MJB3, I-line) and subsequently developed in a tetramethylammonium hydroxide (TMAH) solution (6 %wt.) A hard bake at 150 °C for at least 2 minutes ensures the adhesion chemical resistance of the resist layer to the substrate for the following steps.

### Example 2 - Premaster with undercut

On a support of Si), a 3-4 µm film of a negative resist (NR1-9000PY, NR9-9000PY (Futurex)) is spin coated, and soft baked for 1,5 min at 150 °C. The film is subsequently exposed 2 minutes to UV light through a mask and developed for 45 seconds in Futurex developer after a postexposure bake (100 °C,1 min). The precise amount of undercut can be controlled by carefully adjusting the exposure and development times.

### Example 3 - Premaster multiple layers

Examples 1 and 2 are combined, forming a multilayered premaster. starting with either the negative or positive resist. After irradiation, development and baking (Examples 1 and 2), a second layer of a positive or negative resist is deposited via spin coating and irradiation takes place through a second mask (different from the first mask). Depending on the type of resist, the steps as described in Example 1 and 2 are used to develop and fixate the second resist layer. This way a premaster having multiple functionalised layers, providing a specific 3 dimensional structure is formed.

### Example 4 - Master

The substrate described above is dipped into a solution containing 0.5 vol% APTS (aminopropyltriethoxysilane) in water and taken out of the solution in a controlled way: perpendicular to the liquid surface at a speed of 1 mm/s using a dip coater apparatus. The substrate is then allowed to dry for 5 minutes, and brought into a solution of 2.5 g/l tannic acid for 2 minutes, before rinsing in pure water. The substrate is transferred to a solution containing 10 g/l SnCl₂ and 40 ml/l HCl in water for 1 minute and subsequently rinsed in pure water. The sample is subsequently transferred to a solution of 0.25 g/l PdC12 and 2.5 ml/l HCl for 1 minute and again rinsed in pure water. Then, the substrate is transferred to an electroless plating solution, for instance ENPLATE 435 (supplied by Cookson Electronics) for 5 minutes using standard processing conditions. The substrate is transferred to a solution containing 450 g/l Ni(NH₂SO₃)₂ and 40 g/l H₃BO₃ at pH = 4 and T = 52 °C and made cathodic using a current density of i = 30 A dm⁻² for 30 minutes, followed by a rinse in pure water. Finally, the nickel master is separated from substrate by cutting, rinsed with pure water, and the residual photoresist is removed from the nickel form using acetone in an ultrasonic bath. The last step involves rinsing in pure water and drying at the air.

### Example 5 - Stamp

A 10 : 1 (w/w) mixture of Sylgard 184 silicone elastomer and Curing Agent (Dow Corning) was drop-casted on the nickel master and placed under vacuum for 30 minutes. Subsequently, the material was cured by heating at 100 °C for two hours. After cooling to room temperature the elastomeric stamp was carefully peeled from the master.

### Example 6 - Printing the structures

The stamp was charged with a photocurable formulation (e.g. a mixture of an acrylic oligomer (Ebecryl 284 (Cytec), crosslinker (TMPTA (Cytec), reactive diluent (TPGDA (Cray Valley)), and a photoinitiator (Irgacure 819 (Ciba)) and placed on a transparent substrate (e.g. glass). Some pressure was applied to suppress material migration and formation of a residual layer, and facilitate ink transfer. Accordingly, the ink was irradiated with (UV-) light (1 < 400 nm) for 40 seconds through the substrate with the stamp in place. After virtification of the photocurable mixture the stamp was removed by careful peeling, leaving the 3D structures on the substrate. Alternatively, the stamp was pressed into a pre-cast layer (d > 10 mm) of the liquid photocurable formulation with subsequent irradiation and peeling.

### Examples 7-12

Examples 7-12 were carried out in a similar manner as respective Examples 1-6, except that a support of glass was used instead of a support of Si.

## Claims

1. A stamp for preparing a structured layer for use in an organic opto-electric device comprising a body of a curable elastomeric material which body comprises a plurality of cavities shaped in a structure to be obtained in said structured layer.

2. A stamp according to claim 1, wherein the cavities have a longitudinal shape and are positioned in parallel with respect to each other.

3. A stamp according to claim 1 or 2, wherein each cavity has an opening at a free surface of the body, and the cavity narrows towards the opening.

4. A stamp according to any one of claims 1-3, wherein each cavity comprises a first part and a second part and a passage between the first part and the second part, the first part narrowing towards the passage, the second part having an opening at a free surface of the body and wherein said second part is wider than the passage, the first parts of the cavities having a longitudinal shape and being positioned parallel to each other, the second parts of the cavities having a longitudinal shape and being positioned parallel to each other, and at least two of the second parts of the cavities being connected to each other by a cross-connecting passage, said passage having an opening at the free surface of the body which opening extends between the openings of the second parts connected by the cross-connecting passage.

5. A stamp according to any one of claims 1-4, wherein the curable elastomeric material displays wettability properties with respect to an ink which ink comprises a thermocurable material, a electro-magnetic radiation curable material and/or electron beam curable material.

6. A stamp according to claim 5, wherein the curable elastomeric material is permeable to the ink.

7. A stamp according to claim 5, wherein the curable elastomeric material displays capillary properties, allowing the ink to pass through the curable elastomeric material.

8. A method for preparing a stamp for preparing a structured layer for use in an organic opto-electric device, comprising the steps of:
(a) providing a support layer;
(b) applying a positive or negative resist layer onto the support layer;
(c) creating a plurality of cavities in the resist layer, which cavities are shaped in a structure to be obtained in said structured layer;
(d) applying a metal layer onto the resist layer, thus creating a master containing the negative image of the structures prepared in step (c);
(e) clearing the metal master from the support and resist layer;
(f) applying a layer of a curable elastomeric material onto the metal master to form a stamp; and
(g) clearing the stamp so obtained from the metal master.

9. A method according to claim 8, wherein the cavities created in step (c) have a longitudinal shape and are positioned parallel to each other.

10. A method according to claim 8 or 9, wherein each of the cavities created in step (c) has an opening at a free surface of the body, and the cavities narrow towards the opening.

11. A method according to any one of claims 8-10, wherein each of the cavities created in step (c) comprises a first part and a second part and a passage between the first part and the second part, the first part narrowing towards the passage, the second part having an opening at a free surface of the body and wherein said second part is wider than the passage, the first parts of the cavities having a longitudinal shape and being positioned parallel to each other, the second parts of the cavities having a longitudinal shape and being positioned parallel to each other, and at least two of the second parts of the cavities being connected to each other by a cross-connecting passage, said passage having an opening at the free surface of the body which opening extends between the openings of the second parts connected by the cross-connecting passage.

12. A method according to any one of claims 8-11, wherein the support layer comprises glass, metal, polymer or a combination thereof.

13. A method according to any one of claims 8-12, wherein the positive or negative resist layer comprises one or more materials selected from the group consisting of a thermoplastic material, a thermocurable material, an electro-magnetic radiation curable material and an electron beam curable material.

14. A method according to claim 13, wherein the resist layer is a negative resist layer.

15. A method according to claim 13 or 14, wherein the resist layer comprises an electro-magnetic radiation curable material.

16. A method according to any one of claims 8-15, wherein the metal layer is formed by a combination of an initial wet-chemical electroless step and a subsequent electrodeposition step.

17. A method according to any one of claims 8-16, wherein the curable elastomeric material displays wettability properties with respect to an ink which ink comprises a thermocurable material, an electro-magnetic radiation curable material and/or electron beam curable material.

18. A method according to claim 17, wherein the curable elastomeric material is permeable to the ink.

19. A method according to claim 17, wherein the curable elastomeric material displays capillary properties, allowing the ink to pass through the curable elastomeric material.

20. A structured substrate for use in an organic opto-electric device comprising a support layer, a patterned transparent oxide layer that is applied on the support layer, and a three-dimensional structured layer which comprises banks and separators, wherein the structured layer is made of one part.

21. A substrate according to claim 20, wherein the three-dimensional structured layer is applied onto the support layer and/or patterned transparent oxide layer in a single non-lithographic production step using a stamp as described in any one of claims 1-7 or as prepared with a method as described in any one of claims 8-19.

22. An organic opto-electric device comprising a structured substrate as defined in claim 20 or 21.

23. A method for preparing a structured substrate for use in an organic opto-electric device, comprising the steps of:
(a) providing a support layer of which one surface has been coated with a transparent conductive coating;
(b) applying a stamp as described in any one of claims 1-7 or as prepared according to any one of claims 8-19 onto the support layer and/or transparent conductive oxide layer, whereby the lower surface of the stamp is brought into contact with the support layer and/or transparent conductive layer;
(c) establishing a structured layer by filling the cavities of the stamp with an ink which comprises a thermo-curable material, an electro-magnetic radiation curable material and/or an electron beam curable material; and
(d) curing the ink.

24. A method for preparing a structured substrate for use in an organic opto-electric device, comprising the steps of:
(a) providing a support layer of which one surface has been coated with a transparent conductive oxide layer;
(b) applying a stamp as described in any one of claims 1-7 or as prepared according to any one of claims 8-19 onto the non-coated surface of the support layer and/or transparent conductive oxide layer, whereby the lower surface of the stamp is brought into contact with the support layer and/or transparent conductive layer, wherein the cavities of the stamp were pre-filled with an ink which comprises a thermocurable material, an electro-magnetic radiation curable material and/or an electron beam curable material; and
(c) curing the ink.

25. A method according to claim 23, wherein the cavities of the stamp are filled in step (c) by means of permeation, capillary filling, or under application of a vacuum.

26. A method according to any one of claims 23-25, wherein the curing in step (c) or (d) involves thermal, electro-magnetic radiation or electron beam curing.
